# FASCICULE DE BREVET EUROPEEN

(11) **EP 3 641 509 B1**
(45) Date de publication et mention de la délivrance du brevet: **07.07.2021**
(21) Numéro de dépôt: 19201203.7
(22) Date de dépôt: 02.10.2019
(51) Int. Cl.: H05K 1/02, H02M 7/06, H02M 1/44, G01R 22/00, H05K 1/18, H02M 7/00

(54) **CARTE ELECTRONIQUE COMPRENANT UN PONT DE REDRESSEMENT**
ELEKTRONISCHE KARTE MIT GLEICHRICHTERBRÜCKE
ELECTRONIC CARD COMPRISING A RECTIFIER BRIDGE

(30) Priorité: 19.10.2018 FR 1859698
(43) Date de publication de la demande: 22.04.2020
(73) Titulaire: Sagemcom Energy & Telecom SAS, 92500 Rueil-Malmaison (FR)
(72) Inventeur: DE LA CRUZ, Fabien, 92500 RUEIL MALMAISON (FR)
(74) Mandataire: Lavaud, Thomas

(56) Documents cités:
- EP-A1- 3 107 120

## Description

L'invention concerne le domaine des cartes électriques comprenant un pont de redressement.

### ARRIERE PLAN DE L'INVENTION

Les ponts de redressement sont utilisés très fréquemment pour produire une tension continue à partir d'une tension alternative apportée sur une carte électrique par une ligne électrique quelconque ou bien par un conducteur électrique quelconque.

On trouve ainsi classiquement un pont de redressement dans un compteur d'énergie électrique raccordé à une ligne de transport d'énergie électrique et destiné à mesurer la consommation d'énergie électrique d'une installation. Lorsque la ligne est une ligne triphasée, un pont de redressement à huit diodes est utilisé. Les huit diodes comprennent six diodes destinées à être reliées aux trois phases ainsi que deux diodes destinées à être reliées au neutre dans le cas où un neutre est utilisé.

Les concepteurs de cartes électriques, et donc, en particulier, de cartes électriques comprenant un pont de redressement, savent bien que, pour réduire les émissions parasites, il convient notamment d'éviter les antennes « non intentionnelles ».

Toute interconnexion métallique peut constituer une antenne non intentionnelle. Si l'interconnexion formant antenne est traversée par un courant radiofréquence, ou bien si son potentiel fluctue, elle peut émettre de l'énergie parasite sous forme d'ondes électromagnétiques.

Il existe deux types de mécanisme de rayonnement générant des émissions parasites.

Le rayonnement peut être induit par une circulation ou par une boucle de courant, qui sont à l'origine d'un champ principalement magnétique.

Le rayonnement peut aussi être induit par une différence de potentiel, qui est à l'origine d'un champ principalement électrique.

Une solution pour réduire les émissions parasites consiste à diminuer les forts appels de courant et les fluctuations de tension en ajoutant des filtres passifs ou des capacités de découplage.

Cette solution requiert l'utilisation d'un certain nombre de composants dédiés à la tenue des exigences normatives de compatibilité électromagnétique. Ces composants sont relativement coûteux. Ils occupent une surface non négligeable sur la carte électrique, ce qui augmente la taille et la masse de la carte électrique. La mise en œuvre de cette solution augmente aussi le temps de mise au point de la carte électrique, et nécessite un certain nombre de passages en laboratoire de compatibilité électromagnétique pour valider la conception et vérifier que les exigences normatives sont tenues.

On note par ailleurs que l'application dans laquelle est utilisée la carte électrique impose souvent des contraintes de conception propres à ladite application. Ainsi, dans le cas de compteurs d'énergie électrique, il est parfois requis que l'implantation de tous les composants électriques soit réalisée sur un même côté de la carte électrique. On impose aussi parfois que la carte électrique comprenne deux couches de cuivre seulement.

La solution choisie pour réduire les émissions parasites doit être compatible avec ces contraintes de conception.

EP 3 107 120 A divulgue une carte électrique comprenant un pont de redressement. Les diodes sont encastrées dans la carte électrique pour réduire l'émissions parasites.

### OBJET DE L'INVENTION

L'invention a pour objet une solution permettant de réduire de manière simple et peu coûteuse les émissions parasites générées par une carte électrique comprenant un pont de redressement, les composants électriques de la carte électrique étant positionnés sur une même face de la carte électrique.

### RESUME DE L'INVENTION

En vue de la réalisation de ce but, on propose une carte électrique comportant un circuit imprimé comprenant des conducteurs de phase agencés chacun pour être connecté à une phase d'une ligne multiphasée, la carte électrique comportant de plus un pont de redressement comprenant des diodes de phase montées sur une même face du circuit imprimé, les diodes de phase comportant, pour chaque conducteur de phase, un couple de diodes de phase comprenant une première diode de phase ayant une anode reliée audit conducteur de phase et une deuxième diode de phase ayant une cathode reliée audit conducteur de phase, les couples de diodes de phase s'étendant successivement selon un axe de positionnement sur la face du circuit imprimé, la première diode de phase et la deuxième diode de phase de chaque couple de diodes de phase étant disposées parallèlement mais en sens inverse l'une par rapport à l'autre.

La disposition des diodes de phase du pont de redressement permet de réduire à la fois le nombre et la surface des boucles de courant, mais aussi le nombre de croisements entre deux pistes de la carte électrique.

On réduit ainsi de manière simple et peu coûteuse les émissions parasites générées par la carte électrique. En effet, cette solution n'utilise pas de composants de protection additionnels qui sont relativement coûteux, encombrants, et dont la mise en œuvre nécessite des efforts de conception et de test importants.

On note que les diodes de phase sont montées sur une même face du circuit imprimé, de sorte que la carte électrique selon l'invention est compatible avec les exigences évoquées plus tôt (implantation des composants sur un même côté de la carte électrique, et carte électrique à deux couches).

On propose de plus un compteur d'énergie électrique comprenant une carte électrique telle que précédemment décrite.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :
- la figure 1 représente un pont de redressement à huit diodes ;
- la figure 2 est un schéma électrique représentant un positionnement général, sur la carte électrique selon l'invention, des diodes du pont de redressement ;
- la figure 3 est un schéma électrique représentant un premier exemple de positionnement particulier, conforme au positionnement général, des diodes du pont de redressement ;
- la figure 4 est un schéma électrique représentant un deuxième exemple de positionnement particulier, conforme au positionnement général, des diodes du pont de redressement ;
- la figure 5 représente les diodes de phase et les diodes de neutre du pont de redressement sur un schéma d'implantation de la carte électrique selon l'invention ;
- la figure 6 est un schéma électrique représentant un troisième exemple de positionnement particulier, conforme au positionnement général, des diodes du pont de redressement, sur lequel figure une boucle de courant ;
- la figure 7 est un schéma électrique représentant un quatrième exemple de positionnement particulier, non conforme au positionnement général, des diodes du pont de redressement, sur lequel figure une boucle de courant.

### DESCRIPTION DETAILLEE DE L'INVENTION

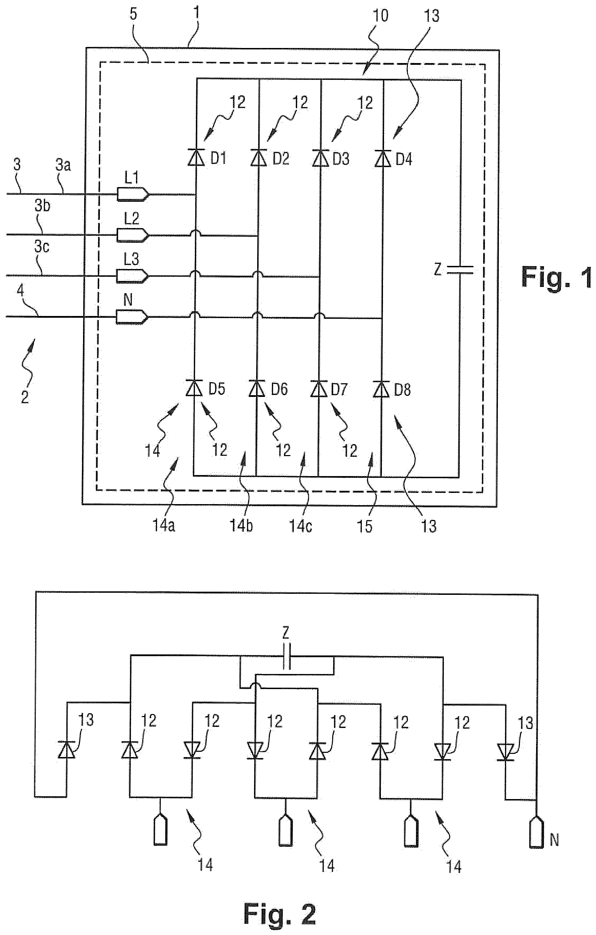

En référence à la figure 1, l'invention est ici mise en œuvre dans un compteur d'énergie électrique 1. Le compteur 1 est raccordé à une ligne de transport d'énergie électrique qui est une ligne multiphasée, en l'occurrence une ligne triphasée 2.

La ligne triphasée 2 comprend trois phases 3 et un neutre 4. Sur chaque phase 3 de la ligne triphasée 2 chemine un courant de phase alternatif, sous une tension de phase alternative. Les trois tensions de phase sont déphasées de 120° et référencées au neutre 4.

Le compteur 1 est utilisé pour mesurer l'énergie électrique fournie par la ligne triphasée 2 à une installation électrique.

L'énergie électrique fournie à l'installation électrique se présente sous la forme d'un courant d'alimentation continu sous une tension d'alimentation continue. Le compteur 1 redresse donc les tensions de phase pour obtenir cette tension d'alimentation continue.

Le compteur 1 comprend une carte électrique selon l'invention 5. La carte électrique 5 comprend un circuit imprimé à deux couches de cuivre comprenant une couche de signaux et un plan de masse.

Le circuit imprimé comprend des conducteurs de phase L1, L2, L3 connectés chacun à une phase 3 distincte de la ligne triphasée 2. Les conducteurs de phase L1, L2, L3 sont ici des pistes formées sur la couche de signaux : chacune de ces pistes est reliée à l'une des phases 3.

Le circuit imprimé comprend aussi un conducteur de neutre N connecté au neutre 4 de la ligne triphasée 2. Le conducteur de neutre N est ici le plan de masse.

Pour redresser les tensions de phase, la carte électrique 5 comporte un pont de redressement 10. La sortie du pont de redressement 10 est ici reliée à une impédance Z.

L'impédance Z représente l'impédance équivalente du compteur électrique. La tension aux bornes de l'impédance Z se rapproche d'une tension continue.

Le pont de redressement 10 comprend des diodes de phase 12 et des diodes de neutre 13.

Les diodes de phase 12 comportent, pour chaque conducteur de phase, un couple de diodes de phase 14 comprenant une première diode de phase ayant une anode reliée audit conducteur de phase et une deuxième diode de phase ayant une cathode reliée audit conducteur de phase. Les diodes de phases 12 comportent donc trois couples de diodes de phase 14 soit six diodes de phase 12.

Un premier couple de diodes de phase 14a, relié à un premier conducteur de phase L1 (et donc à une première phase 3a), comporte une première diode de phase D1 et une deuxième diode de phase D5.

Un deuxième couple de diodes de phase 14b, relié à un deuxième conducteur de phase L2 (et donc à une deuxième phase 3b), comporte une première diode de phase D2 et une deuxième diode de phase D6.

Un troisième couple de diodes de phase 14c, relié à un troisième conducteur de phase L3 (et donc à une troisième phase 3c), comporte une première diode de phase D3 et une deuxième diode de phase D7.

Les diodes de neutre 13 comportent un couple de diodes de neutre 15 comprenant une première diode de neutre D4 et une deuxième diode de neutre D8.

La première diode de neutre D4 a une anode reliée au conducteur de neutre N (et donc au neutre 4), et la deuxième diode de neutre D8 a une cathode reliée au conducteur de neutre N (et donc au neutre 4).

Les diodes de phase 12 et les diodes de neutre 13 sont ici toutes des diodes de référence S1Y du fabricant Diotec, ayant chacune une tension V_{RRM} égale à 2000V et un courant I_{FAV} égal à 1A.

Les diodes de phase 12 et les diodes de neutre 13 sont montées sur une même face du circuit imprimé.

Les chemins de circulation des courants dans le pont de redressement 10 sont les suivants :
- pour les alternances positives :
   ∘ L1-D1-Z-D8-N ;
   ∘ L2-D2-Z-D8-N ;
   ∘ L3-D3-Z-D8-N.
- pour les alternances négatives :
   ∘ L1-D5-Z-D4-N ;
   ∘ L2-D6-Z-D4-N ;
   ∘ L3-D7-Z-D4-N.

La solution proposée ici permet de limiter les boucles de courant au strict besoin fonctionnel, et de limiter au maximum les croisements de pistes. Les croisements de pistes produisent des superpositions de signaux qui peuvent générer des couplages par diaphonie capacitive. Il convient donc de limiter les croisements pour améliorer le comportement électromagnétique de la carte électrique 5.

Dans la carte électrique selon l'invention 5, on positionne à cet effet les diodes conformément à un positionnement général, visible sur la figure 2.

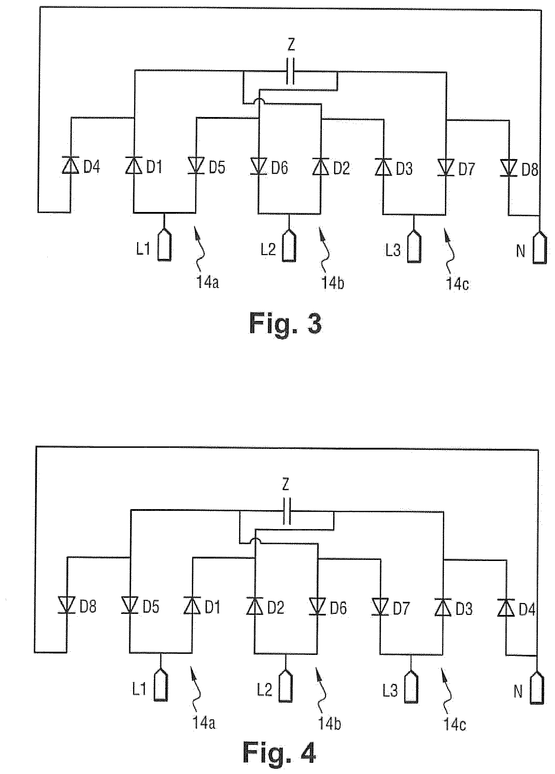

Un premier exemple de positionnement particulier, conforme au positionnement général, est visible sur la figure 3.

Un deuxième exemple de positionnement particulier, conforme au positionnement général, est visible sur la figure 4.

Si l'ordre des phases et du neutre, et donc des conducteurs de phase et du conducteur de neutre, est inversé, par exemple, L1, L3, L2, N ou L2, L1, L3, N ou L2, L3, L1, N ou L3, L1, L2, N ou L3, L2, L1, N ou L1, L3, N, L2 ou L2, L1, N, L3 ou L2, L3, N, L1 ou L3, L1, N, L2 ou L3, L2, N, L1 ou L1, N, L3, L2 ou L2, N, L1, L3 ou L2, N, L3, L1 ou L3, N, L1, L2 ou L3, N, L2, L1 ou N, L1, L3, L2 ou N, L2, L1, L3 ou N, L2, L3, L1 ou N, L3, L1, L2 ou N, L3, L2, L1, il convient de toujours respecter l'alternance du sens des diodes (anode vers le haut ou vers le bas) par paire.

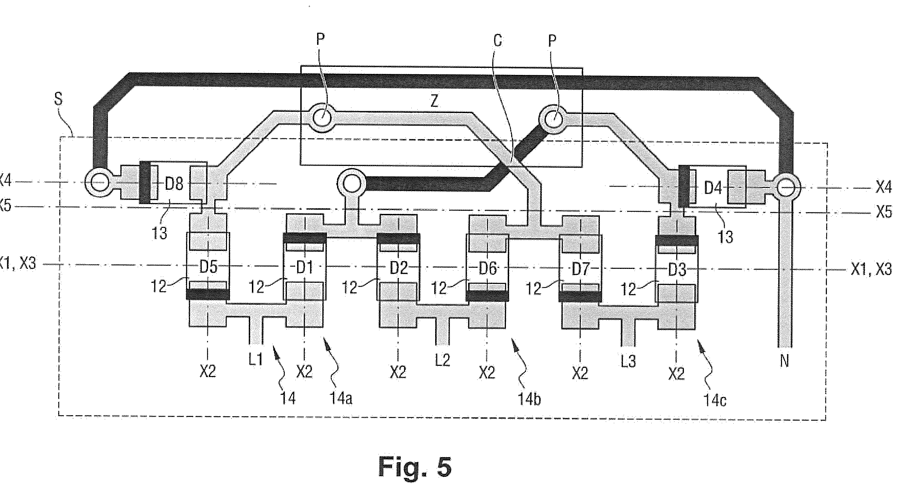

On décrit maintenant plus en détail le positionnement des diodes de phase 12 et des diodes de neutre 13, en référence à la figure 5.

Comme on vient de le voir, les diodes de phase 12 et les diodes de neutre 13 sont montées sur une même face du circuit imprimé.

Les couples de diodes de phase 14 s'étendent successivement selon un axe de positionnement X1.

Ainsi, ici, le premier couple de diodes de phase 14a, le deuxième couple de diodes de phase 14b et le troisième couple de diodes de phase 14c, reliés respectivement au premier conducteur de phase L1, au deuxième conducteur de phase L2 et au troisième conducteur de phase L3, sont disposés successivement, de gauche à droite, selon l'axe de positionnement X1.

Dans chaque couple de diodes de phase 14, la première diode de phase et la deuxième diode de phase sont disposées parallèlement mais en sens inverse l'une par rapport à l'autre, de sorte que l'anode de la première diode de phase est reliée au conducteur de phase correspondant et la cathode de la deuxième diode de phase est reliée au conducteur de phase correspondant.

Ainsi, par exemple, la première diode de phase D1 et la deuxième diode de phase D5 sont disposées parallèlement mais en sens inverse l'une par rapport à l'autre, de sorte que l'anode de la première diode de phase D1 est reliée au premier conducteur de phase L1 et la cathode de la deuxième diode de phase D5 est reliée au premier conducteur de phase L1.

Dans chaque couple de diodes de phase 14, la cathode de la première diode de phase est reliée à la cathode de la première diode de phase du couple de diodes de phase le plus proche de ladite première diode de phase, et/ou l'anode de la deuxième diode de phase est reliée à l'anode de la deuxième diode de phase du couple de diodes de phase le plus proche de ladite deuxième diode de phase.

Ici, en l'occurrence, la cathode de la première diode de phase D1 est reliée à la cathode de la première diode de phase D2, et l'anode de la deuxième diode de phase D6 est reliée à l'anode de la deuxième diode de phase D7.

Chaque diode de phase 12 présente un axe de diode de phase X2 qui passe par un point central, par l'anode et par la cathode de ladite diode de phase 12. Les axes de diode de phase X2 sont parallèles entre eux et sont perpendiculaires à l'axe de positionnement X1. Ainsi, toutes les diodes de phase 12 sont parallèles entre elles.

Les points centraux des diodes de phase 12 sont alignés selon un axe d'alignement X3 parallèle à l'axe de positionnement X1. Par « parallèle », on entend ici parallèle ou bien confondu. Ainsi, toutes les diodes de phase 12 sont ici parfaitement alignées.

La première diode de neutre D4 et la deuxième diode de neutre D8 sont positionnées de sorte que la première diode de neutre D4, les couples de diodes de phase, puis la deuxième diode de neutre D8, s'étendent successivement selon l'axe de positionnement X1.

La cathode de la première diode de neutre est reliée à la cathode de la première diode de phase du couple de diodes de phase de plus proche de la première diode de neutre. L'anode de la deuxième diode de neutre est reliée à l'anode de la deuxième diode de phase du couple de diodes de phase de plus proche de la deuxième diode de neutre.

Ici, en l'occurrence, la cathode de la première diode de neutre D4 est reliée à la cathode de la première diode de phase D3, et l'anode de la deuxième diode de neutre D8 est reliée à l'anode de la deuxième diode de phase D5.

Chaque diode de neutre 13 présente un axe de diode de neutre X4 qui passe par un point central, par l'anode et par la cathode de ladite diode de neutre 13. Les axes de diode de neutre X4 sont confondus et sont parallèles à l'axe de positionnement X1.

La première diode de neutre D4 et la deuxième diode de neutre D8 sont disposées parallèlement et dans le même sens.

Les diodes de phases 12 sont situées dans un premier demi-plan et les diodes de neutre 13 sont situées dans un deuxième demi-plan. Le premier demi-plan et le deuxième demi-plan sont définis par un axe de séparation X5 parallèle à l'axe de positionnement X1.

On note aussi que les diodes de phase 12 et les diodes de neutre 13 sont implantées à l'intérieur d'une surface d'implantation S, et que la sortie du pont de redressement, c'est-à-dire les points de connexion P à l'impédance Z, est située en regard d'une portion centrale de la surface d'implantation S.

Grâce à cette implantation, on a limité le nombre de boucles de courant au strict besoin fonctionnel, c'est-à-dire à la circulation des alternances positives et des alternances négatives du courant.

L'implantation ne présente qu'un seul croisement C, et est très compacte.

Cette solution est très efficace, en particulier dans le cas où les diodes de phase et de neutre et, plus généralement, les composants de la carte électrique, doivent être montés sur une même face d'une carte électrique ayant un circuit imprimé comprenant deux couches de cuivre seulement.

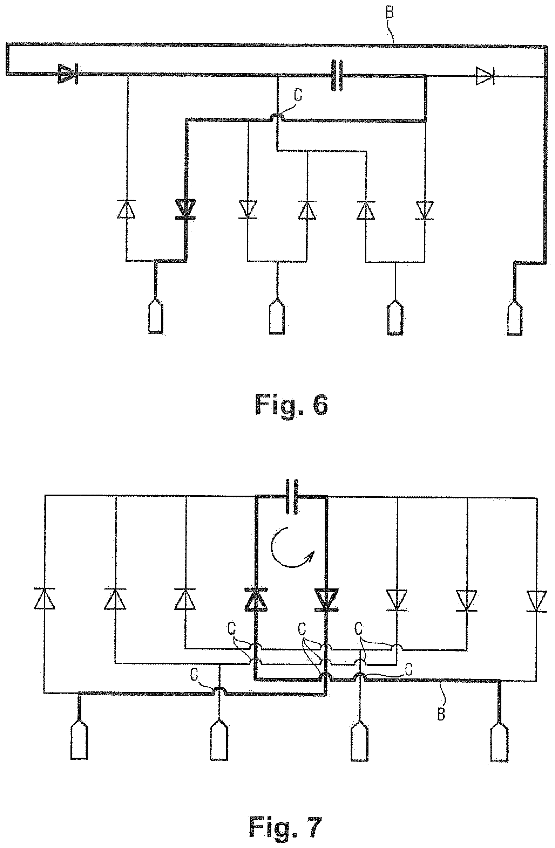

En référence à la figure 6, on voit que, dans le cas de la carte électrique selon l'invention, la surface de la boucle de courant B la plus importante est relativement réduite. Par ailleurs, on note à nouveau que les pistes ne se croisent qu'à une seule reprise au point C, ce qui limite la superposition des signaux.

Par comparaison, en référence à la figure 7, on voit que, dans le cas d'une carte électrique non conforme à l'invention, la surface de la boucle de courant B la plus importante est supérieure. On voit de plus que les pistes se croisent à neuf reprises aux points C. Cette carte électrique non conforme à l'invention est nettement moins performante en matière d'émission parasites.

Bien entendu, l'invention n'est pas limitée au mode de réalisation décrit mais englobe toute variante entrant dans le champ de l'invention telle que définie par les revendications.

L'invention s'applique bien sûr à toute ligne multiphasée, quel que soit le nombre de phases.

La carte électrique selon l'invention n'est pas nécessairement intégrée dans un compteur électrique. La ligne multiphasée n'est pas nécessairement une ligne de transport d'énergie électrique à destination d'une installation. L'invention peut ainsi être mise en œuvre dans tout type d'application dans laquelle un pont de redressement est relié à une ligne ou à un conducteur multiphasé.

La nature et la référence des diodes utilisées sont bien sûr données à titre illustratif et peuvent être différentes.

Le nombre de diodes du pont de redressement peut bien sûr être différent, notamment si le nombre de phases de la ligne multiphasée est différent.

## Revendications

1. Carte électrique comportant un circuit imprimé comprenant des conducteurs de phase (L1, L2, L3) agencés chacun pour être connecté à une phase (3) d'une ligne multiphasée (2), la carte électrique comportant de plus un pont de redressement (10) comprenant des diodes de phase (12) montées sur une même face du circuit imprimé, les diodes de phase comportant, pour chaque conducteur de phase, un couple de diodes de phase (14) comprenant une première diode de phase (D1, D2, D3) ayant une anode reliée audit conducteur de phase et une deuxième diode de phase (D5, D6, D7) ayant une cathode reliée audit conducteur de phase, les couples de diodes de phase s'étendant successivement selon un axe de positionnement (X1) sur la face du circuit imprimé, la première diode de phase et la deuxième diode de phase de chaque couple de diodes de phase étant disposées parallèlement mais en sens inverse l'une par rapport à l'autre.

2. Carte électrique selon la revendication 1, dans laquelle, dans chaque couple de diodes de phase, la cathode de la première diode de phase (D1) est reliée à la cathode d'une première diode de phase (D2) d'un couple de diodes de phase le plus proche de ladite première diode de phase (D1), et/ou l'anode de la deuxième diode de phase (D6) est reliée à l'anode d'une deuxième diode de phase (D7) d'un couple de diodes de phase le plus proche de ladite deuxième diode de phase (D6).

3. Carte électrique selon l'une des revendications précédentes, dans laquelle chaque diode de phase (12) présente un axe de diode de phase (X2) qui passe par un point central, par l'anode et par la cathode de ladite diode de phase, les axes de diode de phase étant parallèles entre eux et étant perpendiculaires à l'axe de positionnement (X1).

4. Carte électrique selon la revendication 3, dans laquelle les points centraux des diodes de phase sont alignés selon un axe d'alignement (X3) parallèle à l'axe de positionnement (X1).

5. Carte électrique selon la revendication 1, le circuit imprimé comprenant un conducteur de neutre (N) agencé pour être connecté à un neutre (4) de la ligne multiphasée (2), le pont de redressement comportant en outre un couple de diodes de neutre (15) comprenant une première diode de neutre (D4) et une deuxième diode de neutre (D5) montées sur la même face du circuit imprimé, la première diode de neutre ayant une anode reliée au conducteur de neutre et la deuxième diode de neutre ayant une cathode reliée au conducteur de neutre, la première diode de neutre et la deuxième diode de neutre étant positionnées de sorte que la première diode de neutre, les couples de diodes de phase, puis la deuxième diode de neutre, s'étendent successivement selon l'axe de positionnement (X1) sur la face du circuit imprimé.

6. Carte électrique selon la revendication 5, dans laquelle la cathode de la première diode de neutre (D4) est reliée à la cathode d'une première diode de phase (D3) d'un couple de diodes de phase le plus proche de ladite première diode de neutre (D4), et dans laquelle l'anode de la deuxième diode de neutre (D8) est reliée à l'anode d'une deuxième diode de phase (D5) d'un couple de diodes de phase le plus proche de ladite deuxième diode de neutre (D8).

7. Carte électrique selon la revendication 5, dans laquelle chaque diode de neutre présente un axe de diode de neutre (X4) qui passe par un point central, par l'anode et par la cathode de ladite diode de neutre, les axes de diode de neutre étant confondus et étant parallèles à l'axe de positionnement (X1).

8. Carte électrique selon la revendication 5, dans laquelle la première diode de neutre (D4) et la deuxième diode de neutre (D8) sont disposées parallèlement et dans le même sens.

9. Carte électrique selon la revendication 5, dans laquelle les diodes de phases (12) sont situées dans un premier demi-plan et les diodes de neutre (13) sont situées dans un deuxième demi-plan, le premier demi-plan et le deuxième demi-plan étant définis par un axe de séparation (X5) parallèle à l'axe de positionnement.

10. Carte électrique selon la revendication 5, dans laquelle les diodes de phase et les diodes de neutre sont implantées à l'intérieur d'une surface d'implantation (S), et dans laquelle une sortie du pont de redressement (10) est située en regard d'une portion centrale de la surface d'implantation (S).

11. Carte électrique selon la revendication 5, dans laquelle le conducteur de neutre est un plan de masse du circuit imprimé.

12. Carte électrique selon l'une des revendications précédentes, dans laquelle le circuit imprimé a deux couches de cuivre.

13. Compteur d'énergie électrique (1) comprenant une carte électrique (5) selon l'une des revendications précédentes.

## Patentansprüche

1. Elektrische Karte, umfassend eine gedruckte Schaltung, die Phasenleiter (L1, L2, L3) umfasst, die jeweils angeordnet sind, um mit einer Phase (3) einer mehrphasigen Leitung (2) verbunden zu werden, wobei die elektrische Karte außerdem eine Gleichrichterbrücke (10) umfasst, die Phasendioden (12) enthält, die auf einer selben Fläche der gedruckten Schaltung angebracht sind, wobei die Phasendioden für jeden Phasenleiter ein Phasendioden-Paar (14) umfassen, das eine erste Phasendiode (D1, D2, D3) enthält, die eine mit dem genannten Phasenleiter verbundene Anode hat, sowie eine zweite Phasendiode (D5, D6, D7), die eine mit dem genannten Phasenleiter verbundene Kathode hat, wobei sich die Phasendioden-Paare nacheinander entlang einer Positionierungsachse (X1) auf der Fläche der gedruckten Schaltung erstrecken, wobei die erste Phasendiode und die zweite Phasendiode jedes Phasendioden-Paars parallel, jedoch in entgegengesetzter Richtung zueinander angeordnet sind.

2. Elektrische Karte nach Anspruch 1, bei der in jedem Phasendioden-Paar die Kathode der ersten Phasendiode (D1) mit der Kathode einer ersten Phasendiode (D2) eines Phasendioden-Paars verbunden ist, das der ersten Phasendiode (D1) am nächsten ist, und/oder die Anode der zweiten Phasendiode (D6) mit der Anode einer zweiten Phasendiode (D7) eines Phasendioden-Paares verbunden ist, das der genannten zweiten Phasendiode (D6) am nächsten ist.

3. Elektrische Karte nach einem der vorhergehenden Ansprüche, bei der jede Phasendiode (12) eine Phasendioden-Achse (X2) aufweist, die durch einen zentralen Punkt, durch die Anode und durch die Kathode der genannten Phasendiode geht, wobei die Phasendioden-Achsen parallel zueinander und senkrecht zur Positionierungsachse (X1) sind.

4. Elektrische Karte nach Anspruch 3, bei der die zentralen Punkte der Phasendioden entlang einer Ausrichtungsachse (X3) ausgerichtet sind, die parallel zur Positionierungsachse (X1) ist.

5. Elektrische Karte nach Anspruch 1, wobei die gedruckte Schaltung einen Neutralleiter (N) umfasst, der ausgebildet ist, um mit einem Neutralleiter (4) der mehrphasigen Leitung (2) verbunden zu werden, wobei die Gleichrichterbrücke ferner ein Neutraldioden-Paar (15) umfasst, das eine erste Neutraldiode (D4) und eine zweite Neutraldiode (D5) enthält, die auf derselben Fläche der gedruckten Schaltung angebracht sind, wobei die erste Neutraldiode eine mit dem Neutraleiter verbundene Anode hat und die zweite Neutraldiode eine mit dem Neutralleiter verbundene Kathode hat, wobei die erste Neutraldiode und die zweite Neutraldiode derart positioniert sind, dass sich die erste Neutraldiode, die Phasendioden-Paare und dann die zweite Neutraldiode nacheinander entlang der Positionierungsachse (X1) auf der Fläche der gedruckten Schaltung erstrecken.

6. Elektrische Karte nach Anspruch 5, bei der die Kathode der ersten Neutraldiode (D4) mit der Kathode einer ersten Phasendiode (D3) eines Phasendioden-Paares verbunden ist, das der genannten ersten Neutraldiode (D4) am nächsten ist, und bei der die Anode der zweiten Neutraldiode (D8) mit der Anode einer zweiten Phasendiode (D5) eines Phasendioden-Paares verbunden ist, das der genannten zweiten Neutraldiode (D8) am nächsten ist.

7. Elektrische Karte nach Anspruch 5, bei der jede Neutraldiode eine Neutraldioden-Achse (X4) aufweist, die durch einen zentralen Punkt, durch die Anode und durch die Kathode der genannten Neutraldiode geht, wobei die Neutraldioden-Achsen zusammenfallen und parallel zur Positionierungsachse (X1) sind.

8. Elektrische Karte nach Anspruch 5, bei der die erste Neutraldiode (D4) und die zweite Neutraldiode (D8) parallel und in der gleichen Richtung angeordnet sind.

9. Elektrische Karte nach Anspruch 5, bei der sich die Phasendioden (12) in einer ersten Halbebene befinden und sich die Neutraldioden (13) in einer zweiten Halbebene befinden, wobei die erste Halbebene und die zweite Halbebene von einer Trennungsachse (X5) definiert sind, die parallel zur Positionierungsachse ist.

10. Elektrische Karte nach Anspruch 5, bei der die Phasendioden und die Neutraldioden innerhalb einer Implantationsfläche (S) implantiert sind und bei der sich ein Ausgang der Gleichrichterbrücke (10) gegenüber einem zentralen Abschnitt der Implantationsfläche (S) befindet.

11. Elektrische Karte nach Anspruch 5, bei der der Neutralleiter eine Masseebene der gedruckten Schaltung ist.

12. Elektrische Karte nach einem der vorhergehenden Ansprüche, bei der die gedruckte Schaltung zwei Kupferschichten hat.

13. Stromzähler (1), umfassend eine elektrische Karte (5) nach einem der vorhergehenden Ansprüche.

## Claims

1. Circuit board comprising a printed circuit comprising phase conductors (L1, L2, L3), each of which is arranged so as to be connected to one phase (3) of a multiphase line (2), the circuit board further comprising a rectifier bridge (10) comprising phase diodes (12) that are mounted on one and the same face of the printed circuit, the phase diodes comprising, for each phase conductor, one pair of phase diodes (14) comprising a first phase diode (D1, D2, D3) having an anode that is connected to said phase conductor and a second phase diode (D5, D6, D7) having a cathode that is connected to said phase conductor, the pairs of phase diodes lying in succession along a positioning axis (X1) on the face of the printed circuit, the first phase diode and the second phase diode of each pair of phase diodes being positioned in parallel but inverted with respect to each other.

2. Circuit board according to Claim 1, wherein, in each pair of phase diodes, the cathode of the first phase diode (D1) is connected to the cathode of a first phase diode (D2) of a pair of phase diodes that is closest to said first phase diode (D1), and/or the anode of the second phase diode (D6) is connected to the anode of a second phase diode (D7) of a pair of phase diodes that is closest to said second phase diode (D6).

3. Circuit board according to either of the preceding claims, wherein each phase diode (12) has a phase diode axis (X2) that passes through a central point, through the anode and through the cathode of said phase diode, the phase diode axes being parallel to one another and being perpendicular to the positioning axis (X1).

4. Circuit board according to Claim 3, wherein the central points of the phase diodes are aligned along an alignment axis (X3) that is parallel to the positioning axis (X1).

5. Circuit board according to Claim 1, the printed circuit comprising a neutral conductor (N) that is arranged so as to be connected to a neutral (4) of the multiphase line (2), the rectifier bridge further comprising a pair of neutral diodes (15) comprising a first neutral diode (D4) and a second neutral diode (D5) that are mounted on the same face of the printed circuit, the first neutral diode having an anode that is connected to the neutral conductor and the second neutral diode having a cathode that is connected to the neutral conductor, the first neutral diode and the second neutral diode being positioned such that the first neutral diode, the pairs of phase diodes and then the second neutral diode lie in succession along the positioning axis (X1) on the face of the printed circuit.

6. Circuit board according to Claim 5, wherein the cathode of the first neutral diode (D4) is connected to the cathode of a first phase diode (D3) of a pair of phase diodes that is closest to said first neutral diode (D4), and wherein the anode of the second neutral diode (D8) is connected to the anode of a second phase diode (D5) of a pair of phase diodes that is closest to said second neutral diode (D8).

7. Circuit board according to Claim 5, wherein each neutral diode has a neutral diode axis (X4) that passes through a central point, through the anode and through the cathode of said neutral diode, the neutral diode axes being coincident and being parallel to the positioning axis (X1).

8. Circuit board according to Claim 5, wherein the first neutral diode (D4) and the second neutral diode (D8) are positioned in parallel and facing the same direction.

9. Circuit board according to Claim 5, wherein the phase diodes (12) are located in a first half-plane and the neutral diodes (13) are located in a second half-plane, the first half-plane and the second half-plane being defined by a separation axis (X5) that is parallel to the positioning axis.

10. Circuit board according to Claim 5, wherein the phase diodes and the neutral diodes are installed within an installation area (S), and wherein an output of the rectifier bridge (10) is located facing a central portion of the installation area (S).

11. Circuit board according to Claim 5, wherein the neutral conductor is a ground plane of the printed circuit.

12. Circuit board according to one of the preceding claims, wherein the printed circuit has two layers of copper.

13. Electricity meter (1) comprising a circuit board (5) according to one of the preceding claims.
